# EUROPEAN PATENT APPLICATION

(11) **EP 3 343 767 A1**
(43) Date of publication of application: **04.07.2018**
(21) Application number: 17205843.0
(22) Date of filing: 07.12.2017
(51) Int. Cl.: H03K 17/0812, H03K 17/12, G05F 1/56, H05B 33/08

(54) **INTEGRATED DRIVE CIRCUIT**

(30) Priority: 27.12.2016 JP 2016253452
(71) Applicant: Kabushiki Kaisha Tokai Rika Denki Seisakusho, Ohguchi-cho Niwa-gun Aichi 480-0195 (JP)
(72) Inventor: AOKI, Daisuke, Niwa-gun, Aichi 480-0195 (JP)
(74) Representative: TBK

(57) **Abstract**

An integrated drive circuit that includes: a first drive unit that includes a first current path connected to a first load, a first drive current that drives the first load flowing through the first current path in a case in which the first drive unit is input with the first drive signal and the first detection signal; and a second drive unit that includes a second current path connected to a second load, a second drive current that drives the second load flowing through the second current path in a case in which the second drive unit is input with the second drive signal and the first detection signal.

## Description

### BACKGROUND

### TECHNICAL FIELD

The present disclosure relates to an integrated drive circuit and a drive system, and particularly relates to an integrated drive circuit that drives plural loads and a drive system constructed including the integrated drive circuit and the plural loads.

### RELATED ART

Japanese Patent No. 5434170 describes an overcurrent protection device. Between an external input terminal and an external output terminal, this overcurrent protection device includes a driver transistor, an overcurrent limiting circuit, and an overcurrent detection circuit. The driver transistor drives a load. The overcurrent limiting circuit controls the gate voltage of the driver transistor, and excess current is limited by the overcurrent limiting circuit. The overcurrent detection circuit detects current flowing between the source region and the drain region of the driver transistor and controls a gate voltage of the driver transistor.

When simultaneously driving plural loads, the amount of drive current increases, and excess heat arises due to the current. In cases in which the overcurrent protection device is used to limit excess current, an overcurrent limiting circuit and an overcurrent detection circuit is needed for each of plural driver transistors respectively driving the plural loads. The scale of circuitry in such an overcurrent protection device thus increases in accordance with the increase in the number of loads, and so there is room for improvement.

### SUMMARY

In consideration of the above circumstances, the present disclosure provides an integrated drive circuit and a drive system in which drive currents for driving plural loads can be limited effectively and circuit scale reduced.

An integrated drive circuit according to a first aspect of the present disclosure includes a multi-input detection circuit, a first drive unit, and a second drive unit. The multi-input detection circuit outputs a first detection signal when input with one of a first drive signal or a second drive signal, and outputs a second detection signal when input with both the first drive signal and the second drive signal. The first drive unit includes a first current path connected to a first load, a first drive current for driving the first load flows through the first current path when the first drive unit is input with the first drive signal and the first detection signal, the amount of the first drive current is limited when the first drive unit is input with the first drive signal and the second detection signal. The second drive unit includes a second current path connected to a second load, a second drive current for driving the second load flows through the second current path when the second drive unit is input with the second drive signal and the first detection signal, the amount of the second drive current is limited when the second drive unit is input with the second drive signal and the second detection signal.

The integrated drive circuit according to the first aspect includes the multi-input detection circuit, the first drive unit, and the second drive unit. The multi-input detection circuit outputs the first detection signal when input with one of the first drive signal or the second drive signal. The multi-input detection circuit outputs the second detection signal when input with both the first drive signal and the second drive signal.

The first drive unit includes the first current path connected to the first load. The first drive current for driving the first load flows through the first current path when the first drive unit is input with the first drive signal and the first detection signal, and the amount of the first drive current is limited when the first drive unit is input with the first drive signal and the second detection signal.

The second drive unit includes the second current path connected to a second load. The second drive current for driving the second load flows through the second current path when the second drive unit is input with the second drive signal and the first detection signal, and the amount of the second drive current is limited when the second drive unit is input with the second drive signal and the second detection signal.

Note that the integrated drive circuit includes one multi-input detection circuit for plural drive units, these being the first drive unit and the second drive unit. When plural drive signals, these being the first drive signal and the second drive signal, have been input via the multi-input detection circuit, it is possible to limit the amount of the first drive current or the second drive current.

An integrated drive circuit according to a second aspect of the present disclosure is the integrated drive circuit according to the first aspect, wherein the first drive unit is configured such that a first drive transistor and a second drive transistor are electrically connected in parallel to the first current path, with operation of the first drive transistor being controlled based on the first drive signal and operation of the second drive transistor being controlled based on the first drive signal and either the first detection signal or the second detection signal. Further, the second drive unit is configured such that a third drive transistor and a fourth drive transistor are electrically connected in parallel to the second current path, with operation of the third drive transistor being controlled based on the second drive signal and operation of the fourth drive transistor being controlled based on the second drive signal and either the first detection signal or the second detection signal.

In the integrated drive circuit according to the second aspect, the first drive unit is configured such that the first drive transistor and the second drive transistor are electrically connected in parallel to the first current path. Operation of the first drive transistor is controlled based on the first drive signal. Operation of the second drive transistor is controlled based on the first drive signal and either the first detection signal or the second detection signal. In the first drive unit, the first drive transistor and the second drive transistor operate based on the first drive signal and the first detection signal such that the first drive current flows through the first current path. However, in the first drive unit, although the first drive transistor operates based on the first drive signal and the second detection signal, the second drive transistor does not operate based on the first drive signal and the second detection signal, and thus the first drive current flowing in the first current path is limited.

Further, the second drive unit is configured such that the third drive transistor and the fourth drive transistor are electrically connected in parallel to the second current path. Operation of the third drive transistor is controlled based on the second drive signal. Operation of the fourth drive transistor is controlled based on the second drive signal and either the first detection signal or the second detection signal. In the second drive unit, the third drive transistor and the fourth drive transistor operate based on the second drive signal and the first detection signal such that the second drive current flows through the second current path. However, in the second drive unit, although the third drive transistor operates based on the second drive signal and the second detection signal, the fourth drive transistor does not operate based on the second drive signal and the second detection signal, and thus the second drive current flowing in the second current path is limited.

An integrated drive circuit according to a third aspect of the present disclosure is the integrated drive circuit according to the second aspect, wherein each of the first drive transistor, the second drive transistor, the third drive transistor, and the fourth drive transistor is configured by a first insulated-gate field-effect transistor, and the multi-input detection circuit is configured including an AND element and an OR element configured by combinations of second insulated-gate field-effect transistors that have a smaller gate length dimension than a gate length dimension of the first insulated-gate field-effect transistors.

In the integrated drive circuit according to the third aspect, each of the first drive transistor and the second drive transistor of the first drive unit, and the third drive transistor and the fourth drive transistor of the second drive unit, is configured by a first insulated-gate field-effect transistor. In contrast, the multi-input detection circuit is configured including an AND element and an OR element configured by combinations of second insulated-gate field-effect transistors.

The gate length dimension of the second insulated-gate field-effect transistors is set so as to be smaller than the gate length dimension of the first insulated-gate field-effect transistors. This enables the circuit scale of the multi-input detection circuit to be reduced.

An integrated drive circuit according to a fourth aspect of the present disclosure includes a multi-input detection circuit and a drive circuit. The multi-input detection circuit outputs a first detection signal when input with one drive signal from out of plural drive signals, and outputs a second detection signal when input with two or more drive signals from out of the plural drive signals. The drive circuit includes plural current paths each connected to a respective one of a plural loads, drive current for driving one load corresponding to the one drive signal flows through one current path when the drive circuit is input with the one drive signal and the first detection signal, and the amount of two or more drive currents for respectively driving two or more loads corresponding to the two or more drive signals is limited in two or more current paths when the drive circuit is input with the two or more drive signals and the second detection signal.

The integrated drive circuit according to the fourth aspect of the present disclosure includes the multi-input detection circuit and the drive circuit. The multi-input detection circuit outputs the first detection signal when input with one drive signal. The multi-input detection circuit outputs the second detection signal when input with two or more drive signals.

The drive circuit includes plural current paths each connected to a respective one of a plural loads. In the drive circuit, drive current for driving one load corresponding to the one drive signal flows through one current path when the drive circuit is input with the one drive signal and the first detection signal. Further, in the drive circuit, the amounts of two or more drive currents for respectively driving two or more loads corresponding to the two or more drive signals is limited in two or more current paths when the drive circuit is input with the two or more drive signals and the second detection signal.

The integrated drive circuit includes one multi-input detection circuit for plural current paths. When two or more drive signals have been input via the multi-input detection circuit, it is possible to limit the amount of the two or more drive currents in the two or more current paths.

A drive system according to a fifth aspect of the present disclosure includes the integrated drive circuit according to any one of the first aspect to the third aspect, a switch circuit, the first load, and the second load. The switch circuit is disposed between the multi-input detection circuit and a power supply. The switch circuit respectively selects the first drive signal and the second drive signal for input to the multi-input detection circuit from the power supply. The first load is connected to the first drive unit via the first current path. The second load is connected to the second drive unit via the second current path.

The drive system according to the fifth aspect includes the integrated drive circuit according to any one of the first aspect to the third aspect, the switch circuit, the first load, and the second load. Thus, the driving system can be constructed having the operation obtained by any of the integrated drive circuits.

An integrated drive circuit and a drive system according to the present disclosure exhibit the excellent advantageous effect of enabling drive currents for driving plural loads to be limited effectively and enabling circuit scale to be reduced.

### BRIEF DESCRIPTION OF THE DRAWINGS

Exemplary embodiments of the present invention will be described in detail based on the following figures, wherein:
Fig. 1 is a circuit block diagram of an integrated drive circuit, and of a drive system configured including the integrated drive circuit, according to an exemplary embodiment of the present disclosure;
Fig. 2 is a logic circuit diagram of a multi-input detection circuit configuring the integrated drive circuit illustrated in Fig. 1;
Fig. 3 is a diagram (truth table) illustrating relationships between drive signals input to the multi-input detection circuit illustrated in Fig. 2 and a detection signal output from the multi-input detection circuit; and
Fig. 4 is a circuit diagram of a drive unit of a driving circuit configuring the integrated drive circuit illustrated in Fig. 1.

### DETAILED DESCRIPTION

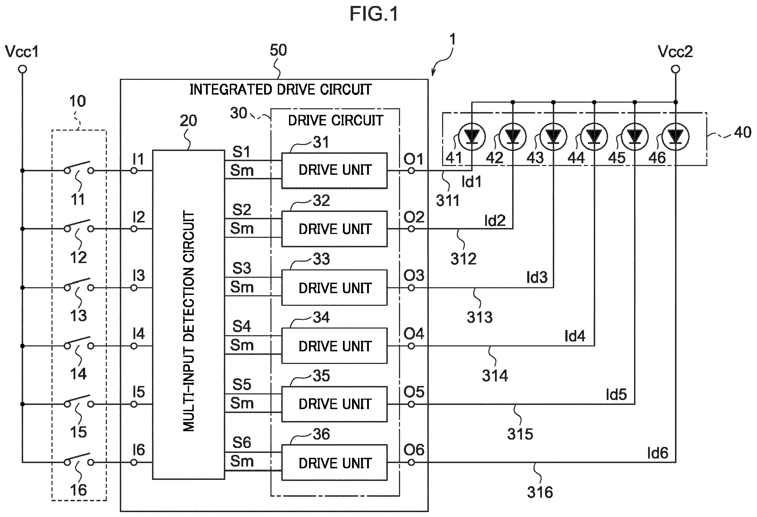

Explanation follows regarding an integrated drive circuit and a drive system according to an exemplary embodiment of the present disclosure, with reference to Fig. 1 to Fig. 4.

### Drive System Configuration

As illustrated in Fig. 1, a drive system 1 according to the present exemplary embodiment is configured including an integrated drive circuit 50 that serves as a semiconductor integrated circuit, a switch circuit 10 incorporated at the input side of the integrated drive circuit 50, and a load 40 incorporated at the output side of the integrated drive circuit 50.

In the present exemplary embodiment, the switch circuit 10 includes plural (six) switch elements 11 to 16. One end of each switch element 11 to 16 is connected to power supply voltage Vcc1. Power supply voltage Vcc1 is, for example, adjusted via a power supply circuit from an onboard vehicle battery voltage to the voltage required for circuit operation, and is, for example, set to 5V. The voltage supplied by power supply voltage Vcc1 is used for drive signals S (S1 to S6) input to the integrated drive circuit 50 via the switch circuit 10.

The other end of each switch element 11 to 16 is connected to a respective input terminal I1 to 16 of the integrated drive circuit 50. Namely, the other end of switch element 11 is connected to the input terminal I1. Similarly, the other end of switch element 12 is connected to the input terminal 12, the other end of switch element 13 is connected to the input terminal 13, the other end of switch element 14 is connected to the input terminal 14, the other end of switch element 15 is connected to the input terminal I5, and the other end of switch element 16 is connected to the input terminal 16.

The load 40 includes plural (six) loads, these being a first load 41 to a sixth load 46, which are each driven by the selection of one of the switch elements 11 to 16. To explain in detail, the first load 41 is driven when switch element 11 is selected, and the second load 42 is driven when the switch element 12 is selected. Similarly, the third load 43 is driven when the switch element 13 is selected, the fourth load 44 is driven when the switch element 14 is selected, the fifth load 45 is driven when the switch element 15 is selected, and the sixth load 46 is driven when the switch element 16 is selected. In the present exemplary embodiment, a light emitting diode (LED) is employed for each of the first load 41 to the sixth load 46.

Power supply voltage Vcc2 is connected to the anode region of each of the first load 41 to the sixth load 46. Similarly to power supply voltage Vcc1, power supply voltage Vcc2 is, for example, set to 5V The cathode regions of the first load 41 to the sixth load 46 are connected to a respective output terminal O1 to O6 of the integrated drive circuit 50 via a first current path 311 to a sixth current path 316, respectively.

### Integrated Drive Circuit Configuration

The integrated drive circuit 50 is configured including the multi-input detection circuit 20 and a drive circuit 30. Plural input terminals of the multi-input detection circuit 20, for which reference numerals have been omitted, are each connected to the respective input terminal I1 to 16 of the integrated drive circuit 50. When the switch element 11 of the switch circuit 10 is selected (switched ON), a first drive signal S1 generated from power supply voltage Vcc1 is input to the input terminal I1, and the first drive signal S1 is input to the multi-input detection circuit 20. Similarly, a second drive signal S2 is input to the input terminal 12 when the switch element 12 is selected, a third drive signal S3 is input to the input terminal 13 when the switch element 13 is selected, and a fourth drive signal S4 is input to the input terminal 14 when the switch element 14 is selected. Further, a fifth drive signal S5 is input to the input terminal I5 when the switch element 15 is selected, and a sixth drive signal S6 is input to the input terminal 16 when the switch element 16 is selected.

Plural output terminals of the multi-input detection circuit 20, for which reference numerals have similarly been omitted, are each connected to the drive circuit 30. In the multi-input detection circuit 20, when, for example, the switch element 11 has been selected, the first drive signal S1 and a detection signal Sm are output to the drive circuit 30 as a pair. The detection signal Sm is either a first detection signal indicating a result that one drive signal S, for example the first drive signal S1, has been detected from out of the plural drive signals, these being the first drive signal S1 to the sixth drive signal S6, or the detection signal Sm is a second detection signal indicating a result that two or more drive signals S, for example the first drive signal S1 and the second drive signal S2, have been simultaneously detected from out of the plural drive signals, these being the first drive signal S1 to the sixth drive signal S6. Note that the circuit configuration of the multi-input detection circuit 20 is explained in detail later.

The drive circuit 30 includes plural (six) drive units, these being a first drive unit 31 to a sixth drive unit 36, which respectively correspond to the first load 41 to the sixth load 46 of the load 40. The input terminal of the first drive unit 31, the reference numeral of which has been omitted, is connected to the multi-input detection circuit 20, and the output terminal of the first drive unit 31, the reference numeral of which has been similarly omitted, is connected to the output terminal O1. The first drive unit 31 is connected to the first load 41 via the output terminal O1. The first drive signal S1 and the detection signal Sm are output from the multi-input detection circuit 20 to the first drive unit 31. A first drive current Id1 that drives the first load 41 flows through the first drive unit 31 via the first current path 311.

Similarly, the input terminal of the second drive unit 32 is connected to the multi-input detection circuit 20, and the output terminal of the second drive unit 32 is connected to the second load 42 via the output terminal 02. A second drive current Id2 that drives the second load 42 flows through the second drive unit 32 via the second current path 312. The input terminal of the third drive unit 33 is connected to the multi-input detection circuit 20, and the output terminal of the third drive unit 33 is connected to the third load 43 via the output terminal 03. A third drive current Id3 that drives the third load 43 flows through the third drive unit 33 via the third current path 313. The input terminal of the fourth drive unit 34 is connected to the multi-input detection circuit 20, and the output terminal of the fourth drive unit 34 is connected to the fourth load 44 via the output terminal 04. A fourth drive current Id4 that drives the fourth load 44 flows through the fourth drive unit 34 via the fourth current path 314. The input terminal of the fifth drive unit 35 is connected to the multi-input detection circuit 20, and the output terminal of the fifth drive unit 35 is connected to the fifth load 45 via the output terminal O5. A fifth drive current Id5 that drives the fifth load 45 flows through the fifth drive unit 35 via the fifth current path 315. Finally, the input terminal of the sixth drive unit 36 is connected to the multi-input detection circuit 20, and the output terminal of the sixth drive unit 36 is connected to the sixth load 46 via the output terminal 06. A sixth drive current Id6 that drives the sixth load 46 flows through the sixth drive unit 36 via the sixth current path 316.

### Multi-Input Detection Circuit Configuration

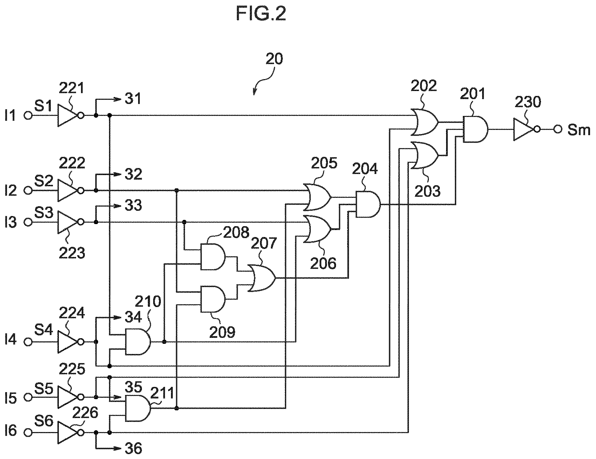

As illustrated in Fig. 2, the multi-input detection circuit 20 is configured by a combination of plural logic elements. Namely, the multi-input detection circuit 20 is configured including plural NOT elements 221 to 226 and 230; plural AND elements 201, 204, and 208 to 211; and plural OR elements 202, 203, and 205 to 207. The AND elements 201 and 204 have three inputs. The AND elements 208 to 211 have two inputs.

To explain in detail, at the first stage of logic, the output of the NOT element 221, the input of which is connected to the input terminal I1, is connected to the first drive unit 31 as illustrated in Fig. 1. The output of the NOT element 221 is also connected to an input of the OR element 202 illustrated in Fig. 2, and to an input of the AND element 210. The output of the NOT element 222, the input of which is connected to the input terminal 12, is connected to the second drive unit 32. The output of the NOT element 222 is also connected to an input of the OR element 205, and to an input of the AND element 209. The output of the NOT element 223, the input of which is connected to the input terminal 13, is connected to the third drive unit 33. The output of the NOT element 223 is also connected to an input of the OR element 206, and to an input of the AND element 208. The output of the NOT element 224, the input of which is connected to the input terminal 14, is connected to the fourth drive unit 34. The output of the NOT element 224 is also connected to an input of the OR element 202, and to an input of the AND element 210. The output of the NOT element 225, the input of which is connected to the input terminal I5, is connected to the fifth drive unit 35. The output of the NOT element 225 is also connected to an input of the OR element 203, and to an input of the AND element 211. The output of the NOT element 226, the input of which is connected to the input terminal 16, is connected to the sixth drive unit 36. The output of the NOT element 226 is also connected to an input of the OR element 203, and to an input of the AND element 211.

At the next stage of logic, the output of the AND element 210 is connected to an input of the OR element 206, and to an input of the AND element 208. The output of the AND element 211 is connected to an input of the OR element 205, and to an input of the AND element 209. The output of the AND element 208 and the output of the AND element 209 are connected to the inputs of the OR element 207, and the output of the OR element 207 is connected to an input of the AND element 204. The output of the OR element 205 and the output of the OR element 206 are connected to inputs of the AND element 204, and the output of the AND element 204 is connected to an input of the AND element 201. The output of the OR element 202 and the output of the OR element 203 are connected to inputs of the AND element 201. At the final stage of logic, the output of the AND element 201 is connected to the NOT element 230. The NOT element 230 outputs the detection signal Sm to each of the first drive unit 31 to the sixth drive unit 36 of the drive circuit 30.

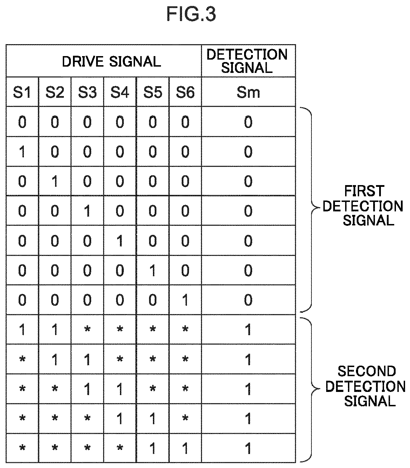

Fig. 3 illustrates relationships (truth table) between drive signals S input to the multi-input detection circuit 20 and the detection signal Sm output from the multi-input detection circuit 20. When input with one drive signal S from out of the plural drive signals, these being the first drive signal S1 to the sixth drive signal S6, for example when input with a first drive signal S1 of "1 (high level)", the multi-input detection circuit 20 outputs a detection signal Sm of "0 (low level)" as the first detection signal. When input with two or more drive signals S from out of the plural drive signals, these being the first drive signal S 1 to the sixth drive signal S6, for example when input with a first drive signal S 1 and a second drive signal S2 of "1", the multi-input detection circuit 20 outputs a detection signal Sm of "1" as the second detection signal. Note that when the plural drive signals, these being the first drive signal S1 to the sixth drive signal S6 are all "0", the multi-input detection circuit 20 outputs the detection signal Sm as first detection signal of "0".

### Configuration of Drive Circuit in Drive Unit

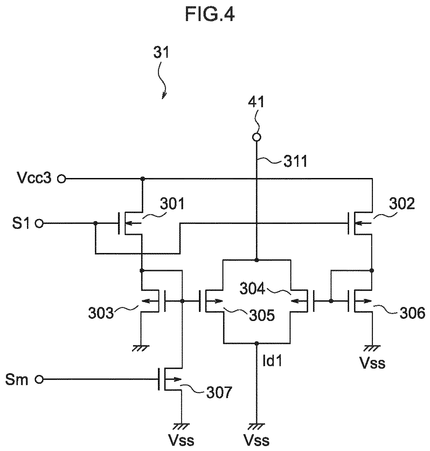

As the first drive unit 31 to the sixth drive unit 36 of the drive circuit 30 illustrated in Fig. 1 all have the same configuration, explanation is only given regarding the configuration of the first drive unit 31. As illustrated in Fig. 4, the first drive unit 31 is configured including a first drive transistor 304 and a second drive transistor 305. The first drive transistor 304 and the second drive transistor 305 are electrically connected, in parallel, to the first current path 311, through which first drive current Id1 flows to the first load 41. The first drive unit 31 is further configured including a first transistor 301, a second transistor 302, a third transistor 303, a fourth transistor 306, and a fifth transistor 307.

The first drive transistor 304 and the second drive transistor 305 are each configured by an n-channel insulated-gate field-effect transistor (IGFET). This type of transistor encompasses at least metal-oxide-semiconductor field-effect transistors (MOSFETs) and metal-insulator-semiconductor field-effect transistors (MISFETs).

One of the main electrodes (the drain electrode) of the first drive transistor 304 is connected to the first load 41 via the first current path 311, and the other of the main electrodes (the source electrode) of the first drive transistor 304 is connected to power supply voltage Vss via the first current path 311. Power supply voltage Vss is a reference voltage for circuit operation, and is, for example, set to 0V. Similarly, one of the main electrodes of the second drive transistor 305 is connected to the first load 41 via the first current path 311, and the other of the main electrodes of the second drive transistor 305 is connected to power supply voltage Vss via the first current path 311.

The first drive transistor 304 and the second drive transistor 305 are each formed with an ON-resistance that is lower than the ON-resistance of transistors that configure the logic elements in the multi-input detection circuit 20, and specifically n-channel FETs. In other words, the gate length (channel width) dimension of each of the first drive transistor 304 and the second drive transistor 305 is set so as to be smaller than the gate length (channel width) dimension of the transistors configuring the logic elements.

The first transistor 301 and the second transistor 302 are each configured by a p-channel IGFET. The third transistor 303, the fourth transistor 306, and the fifth transistor 307 are each configured by an n-channel IGFET.

One of the main electrodes (the source electrode) of each of the first transistor 301 and the second transistor 302 is connected to power supply voltage Vcc3. Here, power supply voltage Vcc3 is set to the same voltage as power supply voltage Vcc1 and power supply voltage Vcc2. The other of the main electrodes (the drain electrode) of the first transistor 301 is connected to one of the main electrodes (the drain electrode) of the third transistor 303. The other of the main electrodes (the drain electrode) of the second transistor 302 is connected to one of the main electrodes (the drain electrode) of the fourth transistor 306. The control electrode (the gate electrode) of each of the first transistor 301 and the second transistor 302 is input with the first drive signal S1. Operation of each of the first transistor 301 and the second transistor 302 is controlled based on the first drive signal S1.

The other of the main electrodes (the source electrode) of the third transistor 303 is connected to power supply voltage Vss, and the control electrode of the third transistor 303 is connected to the control electrode of the second drive transistor 305 and to the one of the main electrodes of the third transistor 303. The second drive transistor 305 and the third transistor 303 configure a mirror circuit. The other of the main electrodes (the source electrode) of the fourth transistor 306 is connected to power supply voltage Vss, and the control electrode of the fourth transistor 306 is connected to the control electrode of the first drive transistor 304 and to the one of the main electrodes of the fourth transistor 306. The first drive transistor 304 and the fourth transistor 306 configure a mirror circuit here too.

One of the main electrodes (the source electrode) of the fifth transistor 307 is connected to the other of the main electrodes of the first transistor 301, to the one of the main electrodes of the third transistor 303 and to the control electrode of the third transistor 303. The other of the main electrodes of the fifth transistor 307 is connected to power supply voltage Vss. The control electrode of the fifth transistor 307 is connected to the multi-input detection circuit 20, and operation of the fifth transistor 307 is controlled based on the detection signal Sm (the first detection signal or the second detection signal) output from the multi-input detection circuit 20.

### Operation and Advantageous Effects of the Present Exemplary Embodiment

As illustrated in Fig. 1, the integrated drive circuit 50 according to the present exemplary embodiment described above includes the multi-input detection circuit 20 and at least the first drive unit 31 and the second drive unit 32. As illustrated in Fig. 3, when input with one of the first drive signal S1 or the second drive signal S2, the multi-input detection circuit 20 outputs a first detection signal of "0". In addition, when input with both the first drive signal S1 and the second drive signal S2, the multi-input detection circuit 20 outputs a second detection signal of "1".

As illustrated in Fig. 1 and Fig. 4, the first drive unit 31 includes the first current path 311 connected to the first load 41. When the first drive unit 31 is input with the first drive signal S 1 and a first detection signal of "0", first drive current Id1 for driving the first load 41 flows through the first current path 311.

To explain in detail, when the switch element 11 of the switch circuit 10 illustrated in Fig. 1 is switched ON, a first drive signal S1 of "1" is input to the input terminal I1. As illustrated in Fig. 2, the first drive signal S1 passes through NOT element 221 and is signal-inverted to "0". Further, in addition to being output to the first drive unit 31, the first drive signal S1 passes through subsequent logic elements in the multi-input detection circuit 20 and is output to the first drive unit 31 as the first detection signal "0" illustrated in Fig. 3.

In the first drive unit 31 illustrated in Fig. 4, the first drive signal S1 is input to the control electrodes of the first transistor 301 and the second transistor 302 so as to switch the first transistor 301 and the second transistor 302 ON. Note that a first detection signal of "0" switches the fifth transistor 307 OFF. Thus, current flows from power supply voltage Vcc3 to power supply voltage Vss through the first transistor 301 and the third transistor 303, and current flows from power supply voltage Vcc3 to power supply voltage Vss through the second transistor 302 and the fourth transistor 306.

When current flows through the fourth transistor 306, a current flows through the first drive transistor 304 configuring the mirror circuit that is half of the first drive current Id1, this being equal to the amount of current flowing through the fourth transistor 306. Further, when current flows through the third transistor 303, a current flows through the second drive transistor 305 configuring the mirror circuit that is half of the first drive current Id1, this being equal to the amount of current flowing through the third transistor 303. Namely, first drive current Id1 in the first current path 311 flows through the first drive transistor 304 and the second drive transistor 305.

In contrast, when both the switch element 11 and the switch element 12 of the switch circuit 10 illustrated in Fig. 1 are switched ON, a first drive signal S1 of "1" is input to the input terminal I1, and a second drive signal S2 of "1" is input to the input terminal 12. As illustrated in Fig. 2, the first drive signal S1 passes through the NOT element 221 and is signal-inverted to "0", and, in addition to being output to the first drive unit 31, the first drive signal S1 passes through subsequent logic elements in the multi-input detection circuit 20 and is output to the first drive unit 31 as the second detection signal "1" illustrated in Fig. 3. Similarly, the second drive signal S2 passes through the NOT element 222 and is signal-inverted to "0", and, in addition to being output to the second drive unit 32, the second drive signal S2 passes through subsequent logic elements in the multi-input detection circuit 20 and is output to the second drive unit 32 as the second detection signal "1".

In the first drive unit 31 illustrated in Fig. 4, the first drive signal S1 is input to the control electrodes of the first transistor 301 and the second transistor 302 so as to switch the first transistor 301 and the second transistor 302 ON. Note that a second detection signal of "1" switches the fifth transistor 307 ON. Thus, although current flows from power supply voltage Vcc3 to power supply voltage Vss through the second transistor 302 and the fourth transistor 306, current does not flow from power supply voltage Vcc3 to power supply voltage Vss through the first transistor 301 and the third transistor 303.

When current flows through the fourth transistor 306, a current flows through the first drive transistor 304 configuring the mirror circuit that is half of the first drive current Id1, this being equal to the amount of current flowing through the fourth transistor 306. However, since current does not flow through the third transistor 303, current does not flow through the second drive transistor 305. In the first current path 311, since only an amount of current that is half of the first drive current Id1 flows through the first drive transistor 304, the amount of first drive current Id1 is limited by half.

Similarly, in the second drive unit 32, the second drive signal S2 switches the first transistor 301 and the second transistor 302 ON, and the fifth transistor 307 is switched ON by a second detection signal of "1". Thus, in the second drive unit 32, since only an amount of current that is half of the second drive current Id2 flows in the second current path 312, the amount of second drive current Id2 is limited by half.

Note that the integrated drive circuit 50 includes one multi-input detection circuit 20 for plural drive units, these being the first drive unit 31 and the second drive unit 32 here. When plural drive signals, these being the first drive signal S 1 and the second drive signal S2, have been input via the multi-input detection circuit 20, it is possible to limit the amount of the first drive current Id1 or the second drive current Id2. This enables plural drive currents, these being the first drive current Id1 and the second drive current Id2 for driving the first load 41 and the second load 42, to be limited effectively, and allows circuit scale to be reduced.

Note that the operation and advantageous effects have been described with respect to a case in which the drive circuit 30 includes two drive units, these being the first drive unit 31 and the second drive unit 32, and the load 40 includes two corresponding loads, these being the first load 41 and the second load 42. However, similar operation and advantageous effects can be obtained even when the integrated drive circuit 50 according to the present exemplary embodiment includes, for example, three or more of the first drive unit 31 and the like and three or more of the first load 41 and the like.

Further, as illustrated in Fig. 4, in the integrated drive circuit 50 according to the present exemplary embodiment, configuration is such that in the drive circuit 30, the first drive transistor 304 and the second drive transistor 305 of the first drive unit 31 are electrically connected in parallel to the first current path 311. Operation of the first drive transistor 304 is controlled based on the first drive signal S1. Operation of the second drive transistor 305 is controlled based on the first drive signal S1 and the detection signal Sm, which is either a first detection signal of "0" or a second detection signal of "1". In the first drive unit 31, the first drive transistor 304 and the second drive transistor 305 operate based on the first drive signal S 1 and the first detection signal "0" such that first drive current Id1 flows through the first current path 311. However, in the first drive unit 31, although the first drive transistor 304 operates based on the first drive signal S 1 and the second detection signal "1", the second drive transistor 305 does not operate based on the first drive signal S1 and the second detection signal "1", and thus the amount of first drive current Id1 that flows in the first current path 311 is limited by half.

Further, as illustrated in Fig. 1 and Fig. 4, the first (third) drive transistor 304 and the second (fourth) drive transistor 305 in the second drive unit 32 are configured electrically connected in parallel to the second current path 312. Operation of the first drive transistor 304 is controlled based on the second drive signal S2. Operation of the second drive transistor 305 is controlled based on the second drive signal S2 and the detection signal Sm, which is either a first detection signal of "0" or a second detection signal of "1". In the second drive unit 32, the first drive transistor 304 and the second drive transistor 305 operate based on the second drive signal S2 and the first detection signal "0" such that second drive current Id2 flows through the second current path 312. However, in the second drive unit 32, although the first drive transistor 304 operates based on the second drive signal S2 and the second detection signal "1", the second drive transistor 305 does not operate based on the second drive signal S2 and the second detection signal "1", and thus the amount of second drive current Id2 that flows in the second current path 312 is limited by half.

Further, in the integrated drive circuit 50 according to the present exemplary embodiment, each of the first drive transistor 304 and the second drive transistor 305 in the first drive unit 31 (to the sixth drive unit 36) illustrated in Fig. 4 is configured by a first IGFET. In contrast, the multi-input detection circuit 20 illustrated in Fig. 2 is configured including, for example, the AND element 201 and the like, and the OR element 202 and the like, which are each combinations of second IGFETs.

The gate length dimension of the second IGFETs is set so as to be smaller than the gate length dimension of the first IGFETs. This enables the area occupied by the second IGFETs to be less than the area occupied by the first IGFETs, allowing the circuit scale of the multi-input detection circuit 20 to be reduced.

Further, as illustrated in Fig. 1, the integrated drive circuit 50 according to the present exemplary embodiment includes the multi-input detection circuit 20 and the drive circuit 30. As illustrated in Fig. 3, when input with one drive signal S, for example the first drive signal S1, from out of the plural drive signals, these being the first drive signal S1 to the sixth drive signal S6, the multi-input detection circuit 20 outputs a first detection signal of "0". When input with two or more drive signals S, for example the first drive signal S 1 and the second drive signal S2, from out of the plural drive signals, these being the first drive signal S1 to the sixth drive signal S6, the multi-input detection circuit 20 outputs a second detection signal of "1".

As illustrated in Fig. 1 and Fig. 4, the drive circuit 30 includes plural current paths, these being the first current path 311 to the sixth current path 316, each connected to a respective one of plural loads, these being the first load 41 to the sixth load 46. When the drive circuit 30 is input with one first drive signal S 1 and the first detection signal "0", the first drive current Id1 for driving the first load 41 corresponding to the first drive signal S1 flows through the first current path 311.

Further, suppose that the first drive signal S1, the second drive signal S2, and the second detection signal "1" have been input to the drive circuit 30. In such a case, the amounts of the first drive current Id1 and the second drive current Id2 in the first current path 311 and the second current path 312 for driving the first load 41 and the second load 42 corresponding to the first drive signal S 1 and the second drive signal S2 would be limited.

As illustrated in Fig. 1, the integrated drive circuit 50 includes the one multi-input detection circuit 20 for plural current paths, these being the first current path 311 to the sixth current path 316. When two or more drive signals S, for example the first drive signal S1 and the second drive signal S2, have been input via the multi-input detection circuit 20, it is possible to limit the amount of the first drive current Id1 and the second drive current Id2 in the first current path 311 and the second current path 312.

Further, as illustrated in Fig. 1, the drive system 1 according to the present exemplary embodiment includes the integrated drive circuit 50, the switch circuit 10, and two or more loads from out of the first load 41 to the sixth load 46. Thus, the driving system 1 can be constructed exhibiting the operation and advantageous effects obtained by the integrated drive circuit 50.

### Supplementary Explanation of the Exemplary Embodiment

The present disclosure is not limited to the above exemplary embodiment, and for example the following modifications may be implemented within a range not departing from the spirit of the present disclosure. For example, the loads in the present disclosure are not limited to LEDs, and may be motors. Further, bipolar transistors may be employed as the drive transistors in the drive circuit of the present disclosure.

Further, the ratios of the drive currents respectively flowing through the first drive transistors and the second drive transistors of the drive units in the drive circuit of the present disclosure may be changed. For example, the ratio of the drive currents respectively flowing through the first drive transistors and the second drive transistors may be configured at 4:6. This enables excess heat produced by current in the drive units to be even more efficiently suppressed when plural drive currents have been input.

Further, the present disclosure may be applied to drive systems including from two to five, or seven or more loads. In such a case, the number of drive units in the drive circuit and the number of loads should match.

An integrated drive circuit that includes: a first drive unit that includes a first current path connected to a first load, a first drive current that drives the first load flowing through the first current path in a case in which the first drive unit is input with the first drive signal and the first detection signal; and a second drive unit that includes a second current path connected to a second load, a second drive current that drives the second load flowing through the second current path in a case in which the second drive unit is input with the second drive signal and the first detection signal.

## Claims

1. An integrated drive circuit comprising:
a multi-input detection circuit that outputs a first detection signal in a case in which one of a first drive signal or a second drive signal is input, and that outputs a second detection signal in a case in which both the first drive signal and the second drive signal are input;
a first drive unit that includes a first current path connected to a first load, a first drive current that drives the first load flowing through the first current path in a case in which the first drive unit is input with the first drive signal and the first detection signal, and the amount of the first drive current being limited in a case in which the first drive unit is input with the first drive signal and the second detection signal; and
a second drive unit that includes a second current path connected to a second load, a second drive current that drives the second load flowing through the second current path in a case in which the second drive unit is input with the second drive signal and the first detection signal, and the amount of the second drive current being limited in a case in which the second drive unit is input with the second drive signal and the second detection signal.

2. The integrated drive circuit of claim 1, wherein:
in the first drive unit, a first drive transistor and a second drive transistor are electrically connected in parallel to the first current path, with operation of the first drive transistor being controlled based on the first drive signal and operation of the second drive transistor being controlled based on the first drive signal and either the first detection signal or the second detection signal; and
in the second drive unit, a third drive transistor and a fourth drive transistor are electrically connected in parallel to the second current path, with operation of the third drive transistor being controlled based on the second drive signal and operation of the fourth drive transistor being controlled based on the second drive signal and either the first detection signal or the second detection signal.

3. The integrated drive circuit of claim 2, wherein:
each of the first drive transistor, the second drive transistor, the third drive transistor, and the fourth drive transistor is configured by a first insulated-gate field-effect transistor; and
the multi-input detection circuit is configured including an AND element and an OR element configured by combinations of second insulated-gate field-effect transistors that have a smaller gate length dimension than a gate length dimension of the first insulated-gate field-effect transistors.
